Europäisches Patentamt

European Patent Office

Office européen des brevets

(19)

(11) **EP 0 544 355 B1**

(12) **EUROPÄISCHE PATENTSCHRIFT**

(45) Veröffentlichungstag und Bekanntmachung des Hinweises auf die Patenterteilung:
**05.03.1997 Patentblatt 1997/10**

(51) Int Cl.6: **H03L 7/099**

(21) Anmeldenummer: **92203543.1**

(22) Anmeldetag: **18.11.1992**

(54) **Digitaler Phasenregelkreis**

Digital phase lock loop

Boucle à verrouillage de phase numérique

(84) Benannte Vertragsstaaten:
**DE FR GB IT**

(30) Priorität: **23.11.1991 DE 4138543**

(43) Veröffentlichungstag der Anmeldung:
**02.06.1993 Patentblatt 1993/22**

(73) Patentinhaber:
- **Philips Patentverwaltung GmbH**
  **22335 Hamburg (DE)**
  Benannte Vertragsstaaten:
  **DE**
- **Philips Electronics N.V.**
  **5621 BA Eindhoven (NL)**
  Benannte Vertragsstaaten:
  **FR GB IT**

(72) Erfinder:
- **Möhlmann, Ulrich,**
  **c/o Philips Patentverwalt. GmbH**
  **W-2000 Hamburg 1 (DE)**

- **Onken, Gerd, c/o Philips Patentverwalt. GmbH**
  **W-2000 Hamburg 1 (DE)**
- **Kunze, Dieter, c/o Philips Patentverwalt. GmbH**
  **W-2000 Hamburg 1 (DE)**
- **Wölber, Jörg, c/o Philips Patentverwalt. GmbH**
  **W-2000 Hamburg 1 (DE)**

(74) Vertreter: **von Laue, Hanns-Ulrich, Dipl.-Ing. et al**
**Philips Patentverwaltung GmbH,**
**Röntgenstrasse 24**
**22335 Hamburg (DE)**

(56) Entgegenhaltungen:
**US-A- 5 050 195**

- **ELECTRONICS & COMMUNICATIONS IN JAPAN Bd. 63, Nr. 12, 1. Dezember 1980, SILVER SPRING, US Seiten 65 - 72 SHUJI SUZUKI ET. AL. 'High Speed Digital PLL Using Trigger Oscillators'**

**Beschreibung**

Digitale Phasenregelkreise sind beispielsweise aus US-A-5 050 195 bekannt.

Die Erfindung betrifft einen digitalen Phasenregelkreis (PLL), welcher auf ein rechteckförmiges Eingangssignal mit einer Frequenz $f_E$ einregelt und welcher einen Umschalter aufweist, der auf Rechtecksignale verschiedener Frequenz umgeschaltet wird und dem ein Hauptteiler, welcher mit einem Divisor D arbeitet, nachgeschaltet ist, der das Ausgangssignal des Phasenregelkreises bildet, wobei der Umschalter in Abhängigkeit dieses Ausgangssignals und des Eingangssignals betätigt wird.

Ein bekannter derartiger Phasenregelkreis, der in das IC MN6163 der Firma Matsushita eingebaut ist, weist einen Umschalter auf, welcher zwischen zwei Eingangsfrequenzen umschaltet, von denen eine durch Herunterteilen der anderen gewonnen wird. Zwischen dem Signal, auf das eingeregelt werden soll und dem Ausgangssignal der Schaltung findet ein Exklusiv-Oder-Vergleich statt, in Abhängigkeit dessen der Umschalter zwischen den beiden Eingangsfrequenzen umgeschaltet wird. Dabei wird während der Zeiten, in denen beide Signale gleichzeitig Low-Pegel oder gleichzeitig High-Pegel haben, auf die erste Frequenz und während der übrigen Zeiten auf die zweite Frequenz geschaltet. Diese Schaltung weist vor allem den Nachteil auf, daß die Impulse des Ausgangssignals der Schaltung mit ihrer Vorderflanke nicht symmetrisch zu den Impulsen des Eingangssignals eingeregelt werden. Darüber hinaus ist die Phasenbeziehung zwischen diesen beiden Signalen einem Phasenjitter unterworfen. Die Phasenbeziehung hängt außerdem auch noch von der Impulsbreite der Signale ab, da ständig ein Vergleich zwischen beiden Signalen stattfindet, in Abhängigkeit dessen der Umschalter betätigt wird. Da während der gesamten Zeit ein Phasenvergleich stattfindet, ist der Fang- und Haltebereich der Schaltung relativ groß was für viele Einsatzzwecke unerwünscht ist.

Es ist Aufgabe der Erfindung, einen digitalen Phasenregelkreis der eingangs genannten Art zu schaffen, der einen kleinen Fang- und Haltebereich hat.

Diese Aufgabe ist erfindungsgemäß dadurch gelöst, daß

- daß der Umschalter zwischen einem ersten Rechtecksignal mit der Frequenz $f_1$, einem zweiten Rechtecksignal mit der zweiten Frequenz $f_2$ und einem dritten Rechtecksignal mit der Frequenz $f_3$ umgeschaltet wird, wobei gilt:

$$f_1 \cdot 1/D = f_E \text{ sowie } k \cdot f_1 = f_2 + (k\text{-}1) \cdot f_3,$$

- daß eine Umschaltlogik vorgesehen ist, welche den Umschalter in der Weise steuert, daß er im Zeitraum zwischen zwei Impulsen des Ausgangssignals auf das Signal mit der ersten Frequenz $f_1$ und daß er während eines Impulses des Ausgangssignals und eines ersten Zustands des Eingangssignals auf das Signal mit der zweiten Frequenz $f_2$ und während eines Impulses des Ausgangssignals und eines zweiten Zustands des Eingangssignals auf das Signal mit der dritten Frequenz $f_3$ geschaltet wird,

- und daß für ein Einrasten der Schaltung auf die Vorderflanken der Impulse des Eingangssignals $f_2 > f_3$ bzw. auf die Rückflanken $f_2 < f_3$ gilt.

Dem Umschalter des digitalen Phasenregelkreises werden also drei Rechtecksignale mit drei verschiedenen Frequenzen zugeführt, wobei die oben angegebenen Beziehungen zwischen diesen Frequenzen erfüllt sein müssen. Sowohl die Impulse des Eingangssignals wie auch die des Ausgangssignals stellen ein digitales Signal dar, das grundsätzlich nur zwei Amplitudenwerte annehmen kann. Es ist darüber hinaus gleichgültig, ob das Eingangssignal und/oder das Ausganssignal im Ruhezustand High-Pegel hat und Impulse aufweist, die Low-Pegel haben, oder ob das Umgekehrte gilt. Im folgenden wird für die Erläuterung davon ausgegangen, daß beide Signale in ihrem Ruhezustand Low-Pegel haben und Impulse mit High-Pegel aufweisen.

In jedem Falle gilt, daß für ein Einrasten der Schaltung auf die Vorderflanken der Impulse das zweite Rechtecksignal mit der Frequenz $f_2$ eine höhere Frequenz als das dritte Rechtecksignal mit der Frequenz $f_3$ aufweisen muß. Soll umgekehrt auf die Rückflanken des Eingangssignal gerastet werden, gilt das Umgekehrte.

Es ist eine Umschaltlogik vorgesehen, welche den Umschalter zwischen den drei Rechtecksignalen umschaltet, wobei sein Ausgangssignal dem Hauptteiler zugeführt wird.

Während derjenigen Zeit, in der das Eingangssignal Low-Pegel hat, wird der Umschalter durch die Umschaltlogik auf das Signal mit der ersten Frequenz $f_1$ geschaltet. Während der Impulse des Eingangssignals der Schaltung, welche High-Pegel haben, wird außerdem die Amplitude des Ausgangssignals der Schaltung betrachtet. Weist diese Low-Pegel auf, wird auf das zweite Rechtecksignal mit der zweiten Frequenz geschaltet. Weist sie dagegen High-Pegel auf, so wird auf das dritte Rechtecksignal mit der dritten Frequenz geschaltet. Durch die oben angegebenen Beziehungen der Frequenzen bzw. des Teilungsverhältnisses der Hauptteiler zueinander wird erreicht, daß das Ausgangssignal der Schaltungsanordnung bzw. die in ihm enthaltenen Impulse mit ihrer Vorderflanke zeitlich auf einen vorgebbaren Zeitpunkt während der Impulse des Eingangssignals der Schaltung fallen.

Über die Wahl der Frequenzen $f_1$, $f_2$ und $f_3$ bzw. über die Frequenzverhältnisse zueinander kann bestimmt werden, auf welchen Bereich der Impulse des Eingangssignals der Schaltung eingerastet werden soll. In

der Gleichung $k \cdot f_1 = f_2 + (k-1) \cdot f_3$ kann über den Faktor k dieser Rastzeitpunkt eingestellt werden. k ist eine natürliche Zahl im Zahlenbereich 1 bis unendlich. Wird k = 1 gewählt, so wird auf die Rückflanke der Impulse des Eingangssignals eingerastet; bei k gegen unendlich auf die Rückflanke dieser Impulse. Soll auf die Mitte der Impulse des Eingangssignals gerastet werden, so ist, wie nach einer Ausgestaltung der Erfindung vorgesehen ist, k = 2 zu wählen; es gilt dann: $2f_1 = f_2 + f_3$.

Die Frequenzen der Signale bzw. die in ihnen auftretenden Impulse können also so gewählt werden, daß das Ausgangssignal des Hauptteilers gerade in der Mitte eines Impulses des Eingangssignals von Low- auf High-Pegel wechselt. Ist die Schaltung noch nicht richtig eingerastet und erscheint die Vorderflanke der Impulse des Ausgangssignals der Schaltung zeitlich nach der Mitte der Impulse des Eingangssignals, so ist diejenige Zeit, während der der Umschalter auf das zweite Rechtecksignal mit der zweiten Frequenz $f_2$ geschaltet ist, größer. Dieses relativ höherfrequente Signal erzeugt also mehr Impulse, die dem Teiler D zugeführt werden. Der nächste Ausgangsimpuls des Teilers D erscheint daher relativ früher, so daß also die nächsten Vorderflanken der Ausgangsimpulse zeitlich eher erscheinen und sich auf die Mitte der Impulse des Eingangssignals einregeln. In umgekehrter Weise ist bei nicht eingerastetem Zustand der Schaltung und bei einem Erscheinen der Vorderflanken der Impulse des Ausgangssignals zeitlich vor der Mitte der Impulse des Eingangssignals derjenige Zeitraum, in denen Impulse des zweiten Rechtecksignals dem Hauptteiler zugeführt werden, relativ kleiner und derjenige Zeitraum, in denen Impulse des dritten Rechtecksignals $f_3$ niedrigerer Frequenz dem Hauptteiler zugeführt werden, relativ größer. Dies wiederum führt dazu, daß die Vorderflanken des Ausgangssignals des Teilers beim nächsten Impuls des Eingangssignals relativ später erscheinen, da ihm während des vorigen Impulses relativ weniger Impulse zugeführt wurden. Auf diese Weise wandert die Flanke also beim nächsten Impuls wieder etwas nach hinten, da der Teiler D etwas später ein Ausgangssignal liefert. Auch hier findet ein Einrasten auf die Mitte der Impulse des Eingangssignals statt. Diese Ausführung gilt in entsprechender Weise für k ≠ 2, also für ein Einrasten auf einen Punkt, der nicht in der Mitte der Impulse des Eingangssignals liegt.

Durch das symmetrische Einrasten der Schaltung ist auch ein kleiner Fang- und Haltebereich erzielbar; auch sind beide gleich groß.

Gegenüber der aus dem Stande der Technik bekannten Schaltung hat der erfindungsgemäße digitale Phasenregelkreis darüber hinaus den Vorteil, daß durch die Wahl der verschiedenen Frequenzen sowohl die Frequenzbedingung, d.h. also die gewünschte Frequenz des Ausgangssignals der Schaltung, als auch die Phasenbedingung, d.h. also die Phasenlage von Eingangs- und Ausgangssignal zueinander, unabhängig voneinander in gewünschter Weise einstellbar sind. Die Frequenzbedingung ist dabei einstellbar durch die Wahl der Frequenz $f_1$ und des Divisiors D des Hauptteilers. Diese müssen so ausgelegt sein, daß die Frequenz $f_1$ durch den Divisior D geteilt die Ausgangsfrequenz der Schaltung ergibt bzw. der Frequenz des Eingangssignals, auf das eingerastet werden soll, entspricht.

Die Frequenzen $f_2$ und $f_3$ des zweiten und dritten Rechtecksignals bestimmen die Phasenbedingung, also die relative Lage der Impulse des Ausgangssignals zu den Impulsen des Eingangssignals der Schaltung.

Für einen möglichst einfachen Aufbau der Schaltung ist es vorteilhaft, das erste, zweite und dritte Rechtecksignal aus einem Signal zu generieren. Dazu sind gemäß einer Ausgestaltung der Erfindung Teiler vorgesehen, mittels derer die drei Rechtecksignale mit den Frequenzen $f_1$, $f_2$ und $f_3$ durch Teilung eines Generatorrechtecksignals mit einer Frequenz $f_0$ gewonnen werden.

Aufgrund der oben beschriebenen freien Wahl einerseits der Frequenzbedingung und andererseits der Phasenbedingung ist es dabei möglich, wie nach einer weiteren Ausgestaltung vorgesehen ist, die Teiler mit ganzzahligen Divisoren arbeiten zu lassen. Dies erleichtert den Aufbau der Schaltung und erspart komplizierte Teiler, die mit nicht ganzzahligen Devisoren arbeiten.

Eine weitere Ausgestaltung der Erfindung sieht vor, daß die Frequenz $f_2$ doppelt so groß gewählt ist wie die Frequenz $f_1$ und daß das dritte Rechtecksignal eine Frequenz $f_3 = 0$ hat, d.h. also konstante Amplitude aufweist. Bei dieser Wahl der Frequenzen sind die o.g. Bedingungen für die drei Frequenzen erfüllt und es tritt der Vorteil ein, daß zur Generierung der drei Signale nur noch ein Rechtecksignal und ein Teiler erforderlich sind. Die Schaltung kann dabei, wie nach einer Ausgestaltung vorgesehen ist, so ausgebaut sein, daß ein Rechtecksignal-Generator vorgesehen ist, welcher ein Signal mit der zweiten Frequenz $f_2$ liefert, das einem Teiler mit dem Divisor 2 zugeführt wird, dessen Ausgangssignal das Rechtecksignal mit der ersten Frequenz $f_1$ darstellt.

Gemäß einer weiteren Ausgestaltung ist vorgesehen, daß der Phasenregelkreis in einem Fernsehempfänger zur Detektion der Horizontalsynchronimpulse eines gegebenenfalls empfangenen Fernsehsignals in einem Ausgangssignal eines Tuners des Fernsehempfängers vorgesehen ist. Das oben beschriebene symmetrische Einrasten der Schaltung und der infolgedessen kleine Fang- und Haltebereich ist bei der Detektion der Horizontalsynchronimpulse eines Fernsehsignals besonders gut einsetzbar, da dieser kleine Fang- und Haltebereich dazu führt, daß ein Einfallen auf Störungen unwahrscheinlich ist. Mittels des Phasenregelkreises kann detektiert werden, ob der Fernsehempfänger bzw. der Tuner des Fernsehempfängers ein Fernsehsignal empfängt oder nicht. In Abhängigkeit dieser Erkenntnis können weitere Schaltkreise in dem Fernsehempfänger entsprechend eingestellt werden. Speziell für die Anwendung zur Detektion der Horizontalsynchronimpulse in einem Fernsehsignal ist es vorteilhaft, daß der Rechtecksignal-Generator mit einer Frequenz $f_0 = 843,75$ MHz arbeitet und daß im Hauptteiler eine Division durch $D = 27$ vorgenommen wird. Es ergibt sich hierbei für das Ausgangssignal der Schaltung eine Frequenz, die nahezu exakt der Frequenz des Horizontalsynchronsignals in einem Fernsehsignal entspricht.

Sollen in einem Fernsehempfänger in beschriebener Weise die Horizontalsynchronimpulse eines Fernsehsignals detektiert werden, so ist es vorteilhaft, diese Impulse nicht direkt der Schaltung zuzuführen, da sie meist von Störungen überlagert sind und so ein einwandfreies Arbeiten der Schaltung nicht immer gewährleistet ist. Zur Ausschaltung von Störungen ist es daher vorteilhaft, wie nach einer weiteren Ausgestaltung vorgesehen ist, daß das Ausgangssignal des Tuners einem Amplitudensieb zugeführt wird, mittels dessen die Synchronimpulse abgetrennt werden, welche einem nachgeschalteten, als Integrator wirksamen Tiefpaßfilter zugeführt werden, dessen Ausgangssignal in einem Komparator mit einer Schaltschwelle verglichen wird, wobei bei Überschreiten der Schaltschwelle ein Monoflop angestoßen wird, dessen Ausgangssignal das Eingangssignal des Phasenregelkreises darstellt. Durch die Wahl der Zeitkonstante des Integrators bzw. der Schaltschwelle des Komparators kann dabei die Empfindlichkeit bzw. Unempfindlichkeit der Schaltung sowie die zeitliche Verzögerung beeinflußt werden, mit der der Monoflop ein Ausgangssignal liefert, wenn Horizontalsynchronimpulse durch das Amplitudensieb abgetrennt wurden. Ferner wird durch die Wahl dieser beiden Parameter beeinflußt, wieviele Störimpulse an den Eingang des Phasenregelkreises gelangen. Das Ausgangssignal des Monoflops ist nun ein digitales Signal, das nur zwei Zustände annehmen kann und das durch den Phasenregelkreis weiterverarbeitet werden kann.

Für die Anwendung des Phasenregelkreises in einem Fernsehempfänger ist weiter vorgesehen, daß dem Phasenregelkreis eine Auswerteschaltung nachgeschaltet ist, in welcher ein D-Flipflop vorgesehen ist, dessen D-Eingang das Eingangssignal des Phasenregelkreises und dessen Takteingang das Ausgangssignal des Phasenregelkreises zugeführt wird und dessen Ausgangssignal zwei Stromspiegel steuert, deren Ausgänge einen gegen ein Bezugspotential geschalteten Kondensator geführt werden, wobei eine Stromspiegelschaltung den Kondensator auflädt und die andere ihn entlädt, und daß die Spannung über dem Kondensator einem Komparator zugeführt wird, dessen Ausgangssignal indiziert, ob der Phasenregelkreis auf ein Fernsehsignal mit Horizontalsynchronimpulsen eingerastet hat oder nicht.

Der Ladezustand des Kondensators ist ein Maß dafür, ob die Schaltung gerastet hat oder nicht. Die über dem Kondensator liegende Spannung kann mittels eines Komparators mit Hysteresis, welche Schaltunsicherheiten vernichtet, ausgewertet werden, der seinerseits ein Ausgangssignal liefert, das leicht weiterverarbeitbar ist und das den Rastzustand der Schaltung angibt. Mit der Höhe des Lade- bzw. Entladestromes der beiden Stromspiegel ist die Gewichtung einstellbar. Dabei ist für die Anwendung in einem Fernsehempfänger ein Lade-Entladestromverhältnis von 4 : 1 bis 7 : 1 vorteilhaft. Ist das Stromverhältnis höher, wird auch Rauschen als Signal erkannt, ist es niedriger, wird ein verrauschtes Signal nicht mehr als solches erkannt.

Gemäß einer weiteren Ausgestaltung der Erfindung ist vorgesehen, daß in dem Fernsehempfänger ein Horizontalphasenregelkreis vorgesehen ist, welchem das in einem empfangenen Fernsehsignal enthaltene Horizontalsynchronsignal zugeführt wird, welcher einen Phasenkomparator und einen steuerbaren Oszillator aufweist, daß der Eingang des steuerbaren Oszillators über einen steuerbaren Schalter auf den Ausgang des Phasenkomparators oder einen Ausgang einer Gleichspannungsquelle schaltbar ist, welche eine Spannung liefert, welche den Oszillator auf einer vorgebbaren Soll-Horizontalfrequenz schwingen läßt, und daß der steuerbare Schalter in Abhängigkeit des Ausgangssignals des Komparators so gesteuert wird, daß der steuerbare Oszillator bei nicht gerastetem Phasenregler ein Signal mit der Soll-Horizontalfrequenz abgibt.

Der Fernsehempfänger weist also einen Horizontalphasenregelkreis auf, der auf die Horizontalsynchronimpulse rastet und dessen Ausgangssignal für die Weiterverarbeitung im Fernsehempfänger insbesondere für die Ablenkschaltung zur Darstellung auf einem Bildschirm weiterverarbeitet wird. Der erfindungsgemäße digitale Phasenregelkreis dient in diesem Fall dazu, zu erkennen, ob ein Fernsehsignal empfangen wird oder nicht. Wird kein Fernsehsignal empfangen, so tritt bei den nach dem Stande der Technik bekannten Schaltungen das Problem auf, daß der Horizontalphasenregelkreis eine beliebige Frequenz liefert, da er sich auf keine Eingangsfrequenz mehr einstellen kann. Dies wiederum bedeutet aber, daß die Darstellung auf dem Bildschirm infolge schwankender Horizontalfrequenz nicht mehr möglich ist. Insbesondere können sogenannte On-Screen-Display Darstellungen nicht mehr vorgenommen werden. Der erfindungsgemäße digitale Phasenregelkreis kann in oben beschriebener Weise dazu eingesetzt werden, zu detektieren, ob ein Fernsehsignal empfangen wird oder nicht. Diese Information, die insbesondere dem Ausgangssignal der oben beschriebenen werteschaltung entnommen werden kann, kann nun dazu eingesetzt werden, den Oszillator des Horizontalphasenregelkreises während derjenigen Zeiten, in denen der Komparator der Auswerteschaltung indiziert, daß kein Fernsehsignal empfangen wird, auf seine Nennfrequenz zu schalten. Es ist dann auch, wenn kein Fernsehsignal empfangen wird, eine Darstellung auf dem Bildschirm möglich. So kann beispielsweise auch während eines Sendersuchlaufes eine Darstellung auf dem Bildschirm stattfinden. Diese Darstellung kann beispielsweise in dem Einblenden bestimmter Einstellwerte des Fernsehempfängers gegeben sein.

Anhand der Zeichnung werden einige Ausführungsbeispiele der Erfindung näher erläutert. Es zeigen:

Fig. 1 eine erste Ausführungsform des digitalen Phasenregelkreises,

Fig. 2 eine zweite Ausführungsform des digitalen Phasenregelkreises,

Fig. 3 ein Impulsdiagramm des Phasenregelkreises gemäß Fig. 2,

Fig. 4 den digitalen Phasenregelkreis mit vorgeschaltetem Amplitudensieb, Integrator, Komparator und Monoflop sowie nachgeschalteter Auswerteeinheit und

Fig. 5 die Auswerteeinheit gemäß Fig. 4 sowie ein Blockschaltbild eines Horizontalphasenregelkreises eines sehempfängers.

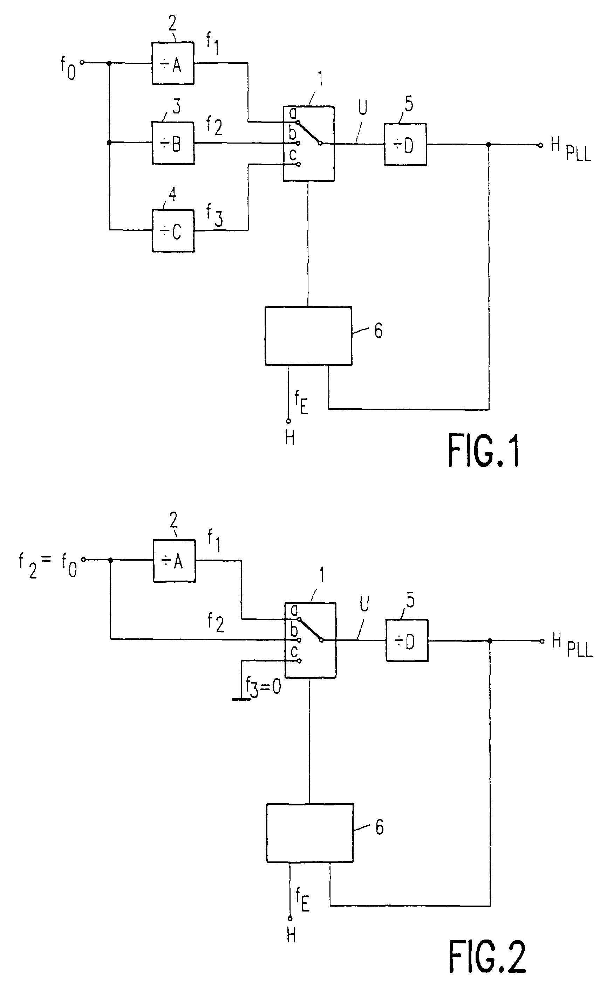

Eine in Fig. 1 dargestellte erste Ausführungsform des erfindungsgemäßen digitalen Phasenregelkreises weist einen Umschalter 1 auf, welcher drei Eingänge aufweist. Für das Umschalten auf die drei Eingänge sind Schaltstellungen a, b und c vorgesehen. Bei dem in der Fig. 1 dargestellten Phasenregelkreis werden die drei diesen Eingängen des Umschalters 1 zugeführte Rechtecksignale aus einem Rechtecksignal mit der Frequenz $f_0$ gewonnen, das seinerseits wiederum aus einem in der Fig. nicht dargestellten Generator stammen kann. Das Rechtecksignal mit der Frequenz $f_0$ wird in einem ersten Teiler 2 durch einen Divisor A geteilt, so daß der Teiler 2 an seinem Ausgang ein Rechtecksignal mit der Frequenz $f_1$ liefert, das dem Umschalter 1 an seinem Schaltkontakt a zugeführt wird.

In einem zweiten Teiler 3 wird das Signal mit der Frequenz $f_0$ durch einen Divisor B geteilt, so daß der Teiler 3 an seinem Ausgang ein zweites Rechtecksignal mit der Frequenz $f_2$ liefert, das dem Schaltkontakt b des Umschalters 1 zugeführt ist.

Für die Generierung des dritten Rechtecksignals mit der Frequenz $f_3$ wird das Signal mit der Frequenz $f_0$ in einem dritten Teiler 4 durch einen Divisor C geteilt. Das dritte Rechtecksignal ist dem Schaltkontakt C des Umschalters 1 zugeführt.

Dem Umschalter 1, der an seinem Ausgang ein Signal U liefert, ist ein Hauptteiler 5 nachgeschaltet, welcher mit einem Divisor D arbeitet. Das Ausgangssignal des Hauptteilers 5 stellt auch das Ausgangssignal des Phasenregelkreises dar, das in der Fig. mit $H_{PLL}$ bezeichnet ist.

Es ist ferner eine Umschaltlogik 6 vorgesehen, der eingangsseitig einerseits das Ausgangssignal des Phasenregelkreises $H_{PLL}$ und andererseits das Eingangssignal, auf das der Phasenregelkreis einregeln soll, zugeführt wird. Dieses Eingangssignal ist in der Fig. mit H bezeichnet; es weist eine Frequenz $f_1$ auf. Die Umschaltlogik 6 steuert in Abhängigkeit dieser Signale den Umschalter 1. Die Umschaltlogik 6 kann selbstverständlich in den Umschalter 1 integriert sein.

Für die Beziehungen der Frequenzen $f_1$, $f_2$, $f_3$, bzw. der Divisoren A, B und C sowie des Divisors D müssen die Bedingungen

$$f_1 \cdot 1/D = f_E \text{ sowie } k \cdot f_1 = f_2 + (k\text{-}1) f_3$$

erfüllt sein. Die Frequenz $f_1$ des ersten Rechtecksignals muß also heruntergeteilt mit dem Divisor D gerade der Frequenz des Eingangssignals entsprechen, auf die die Schaltung einrasten soll. Die Summe der Frequenzen $f_2$ und $f_3$ muß dem doppelten Wert der Frequenz des Signals $f_1$ entsprechen. Dies ist erforderlich, um ein Einrasten der Schaltung zu gewährleisten. Für ein symmetrisches Einrasten ist k = 2 zu wählen.

Für einen möglichst einfachen Aufbau der Schaltung sollten die Teiler 2, 3, 4 und 5 mit ganzzahligen Divisoren arbeiten. Unter Berücksichtigung der o.g. Beziehungen der Frequenzen bzw. der Teiler untereinander können die Divisoren 2, 3 und 4 beispielsweise mit folgenden Divisoren arbeiten:

Tabelle

| A | B | C |
|---|---|---|
| 2 | 1 | 00 |
| 4 | 3 | 6 |
| 6 | 4 | 12 |
| 8 | 5 | 20 |
| 10 | 6 | 30 |
| 12 | 7 | 40 |

Die erste Zeile dieser Tabelle zeigt eine Auslegung, bei der Divisor C eine Auslegung gegen unendlich hat. Dies bedeutet mathematisch nichts anderes, als daß das dritte Rechtecksignal mit der Frequenz $f_3$ eine Frequenz = 0 aufweist. Das Signal hat also immer konstanten Pegel. Die Auslegung der Divisoren gemäß der ersten Zeile zeigt außerdem, daß der Divisor B = 1 ist; es kann also der Teiler 3 völlig entfallen und das Signal $f_0$ gleichzeitig als Signal $f_2$ ausgelegt sein.

Die Fig. 2 zeigt eine zweite Ausführungsform des digitalen Phasenregelkreises, bei dem die Divisoren gemäß der ersten Zeile der Tabelle ausgelegt sind.

Der zweite Teiler 3 gemäß der Schaltung Fig. 1 kann dabei entfallen, da der Divisor B = 1 beträgt. Es kann also das Signal mit der Frequenz $f_0$ unmittelbar als zweites Rechtecksignal mit der Signal $f_2$ eingesetzt werden. Die Frequenz des dritten Signals $f_3$ beträgt 0, so daß der Kontakt c des Umschalters 1 mit einem Signal konstanter Amplitude beaufschlagt werden kann, in der Darstellung gemäß Fig. 2 ist dieser Kontakt auf Masse gelegt.

Die Schaltung gemäß Fig. 2 weist funktional keine Nachteile gegenüber der Schaltung gemäß Fig. 1 auf, es werden aber zwei Teiler eingespart.

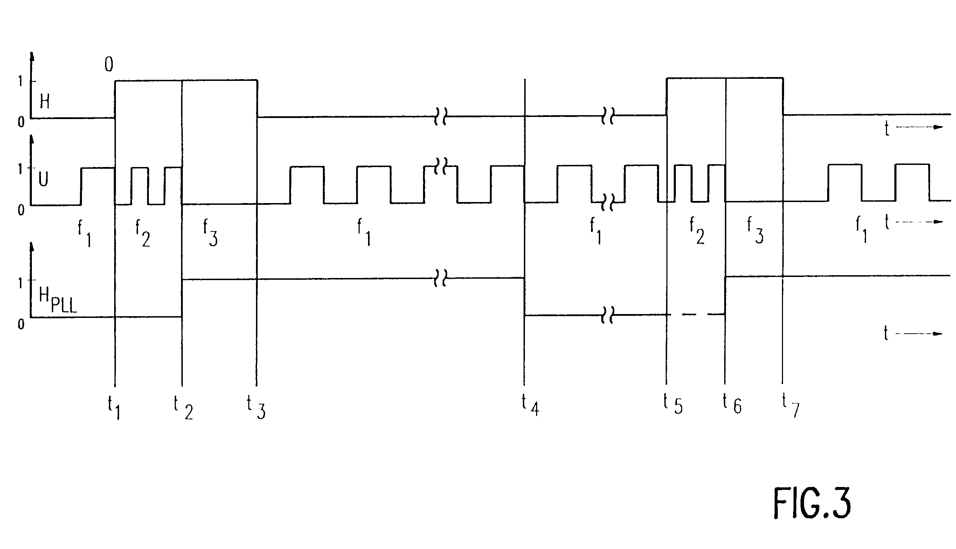

Im folgenden wird die Arbeitsweise der Schaltungen sowohl gemäß Fig. 1 wie auch gemäß Fig. 2 anhand eines in Fig. 3 dargestellten Impulsdiagrammes, in dem einige Signale über der Zeit dargestellt sind, näher erläutert.

Ein erster in Fig 3 dargestellter Kurvenzug zeigt das Eingangssignal H. Dieses Eingangssignal kann zwei Pegel einnehmen, nämlich Low-Pegel, in der Fig. 3 mit 0 gekennzeichnet und High-Pegel, in der Fig. mit 1 gekennzeichnet. Das Signal weist in seinem Ruhezustand Low-Pegel auf. Das Signal weist während in dem Signal enthaltener Impulse High-Pegel auf. Bei diesem Signal H kann es sich insbesondere um ein Horizontalsynchronsignal eines Fernsehsignals handeln bzw. um ein aus diesem Signal abgeleitetes Signal.

Ein zweiter in der Fig. 3 dargestellter Kurvenzug zeigt das Ausgangssignal U des Umschalters 1 der Schaltung gemäß Fig. 2.

Ein dritter Kurvenzug der Darstellung gemäß Fig. 3 zeigt das Ausgangssignal $H_{PLL}$ der Schaltung bzw. das Ausgangssignal des Teilers 5 der Schaltung gemäß Fig. 2.

Die Umschaltlogik 6 des Phasenregelkreises gemäß Fig. 2 steuert den Umschalter 1 in Abhängigkeit des Ausgangssignals $H_{PLL}$ und des Eingangssignals H. Die Darstellung gemäß Fig. 3 zeigt, daß der Umschalter auf seine Position a, also auf das Signal mit der Frequenz $f_1$ während derjenigen Zeiten geschaltet wird, in denen das Eingangssignal H Low-Pegel aufweist. Während dieser Zeiträume spielt der Pegel des Ausgangssignals $H_{PLL}$ der Schaltung für die Schalterposition des Umschalters 6 keine Rolle.

Während derjenigen Zeiten, in denen das Eingangssignal H High-Pegel hat, in denen also ein Impuls in diesem Signal auftritt, wird dagegen auch der momentane Pegel des Ausgangssignals $H_{PLL}$ berücksichtigt. Weist dieses Signal während eines Impulses des Signals H Low-Pegel auf, so wird der Umschalter auf seine Position b, also das Signal mit der Frequenz $f_2$ geschaltet. Weist dagegen während eines Impulses des Signals H das Signal $H_{PLL}$ High-Pegel auf, so wird der Umschalter 1 auf seinen Kontakt c, also das Signal mit der Frequenz $f_3$ geschaltet.

Im folgenden soll anhand der Darstellung gemäß Fig. 3 die Arbeitsweise der Schaltung näher erläutert werden. Die Darstellung gemäß Fig. 3 zeigt den eingerasteten Zustand der Schaltung, d.h. also den Zustand, in dem das Ausgangssignal $H_{PLL}$ mit seinen Vorderflanken genau auf die Mitte der Impulse des Signals H synchronisiert ist.

In diesem synchronisierten bzw. eingeregelten Zustand der Schaltung werden dem Teiler 5 gemäß Fig. 2 entsprechend der Darstellung gemäß Fig. 3 während der Zeitspanne vom Zeitpunkt $t_2$, also dem Zeitpunkt,

zu dem am Ausgang des Teilers 5 das Signal von Low- auf High-Pegel wechselt bis zum Zeitpunkt $t_3$, zu dem die Rückflanke des IMpulses des Eingangssignals erscheint, keine Impulse zugeführt. Ab $t_3$ gelangen die mittels des Teilers 2 heruntergeteilten Impulse auf dem Eingang des Teilers 5. Zum Zeitpunkt $t_4$ erzeugt das dem Teiler 5 zugeführte Eingangssignal unter Herunterteilung um den Divisor D wieder einen Impuls am Ausgang des Teilers 5. Während der nachfolgenden Zeitspanne $t_4$ bis $t_5$, also bis zur Vorderflanke des nächsten Impulses des Eingangssignals H, wird dem Umschalter 6 das mittels des Teilers 2 heruntergeteilte Signal $f_1$ und nachfolgend bis zum Zeitpunkt $t_6$, zu dem das Ausgangssignal des Teilers 5 wieder auf High-Pegel wechselt, das nicht heruntergeteilte Signal $f_2 = f_0$ zugeführt. Der Zähler hat also beispielsweise im Zeitraum $t_2$ bis $t_6$ einmal durchgezählt. Während der Zeitspanne $t_2$ bis $t_3$ wurde dem Teiler 5 dabei das Signal mit der Frequenz $f_3$ zugeführt, das in der Ausführungsform gemäß Fig. 2 eine Frequenz $f_3 = 0$ aufweist, also konstanten Pegel hat. Während der Zeitspanne $t_3$ bis $t_5$ wurde dem Teiler 5 das erste Signal mit der Frequenz $f_1$ zugeführt. Während der Zeitspanne $t_5$ bis $t_6$ wurde dem Teiler das Signal mit der relativ höheren Frequenz $f_2$ zugeführt. Die Werte der Frequenzen $f_1$, $f_2$ und $f_3$ und des Divisors D des Teilers 5 gemäß Fig. 2 sind dabei so gewählt, daß der Teiler in der Zeitspanne t2 bis t6 gerade soviele Impulse erhält, daß ein Ausgangssignal zu den Zeitpunkten $t_2$ und $t_6$, also jeweils in der zeitlichen Mitte der Impulse des Signals H von Low- auf High-Pegel wechselt. Dieser Ablauf setzt sich im synchronisierten Zustand der Schaltung jeweils zwischen zwei Impulsen des Signals H fort.

Im nicht synchronisierten Zustand der Schaltung findet der Übergang zum Zeitpunkt $t_2$ von Low-Pegel auf High-Pegel im Signal $H_{PLL}$ nicht in der zeitlichen Mitte des Impulses des Signals H statt. Gleichwohl wird jedoch vom Zeitpunkt $t_2$ bis zum Zeitpunkt $t_3$, in dem der Impuls des Signals beendet ist, dem Teiler 5d kein Impuls zugeführt. Zwischen den Zeitpunkten $t_3$ und $t_5$ wird dem Teiler die gleiche Zahl von Impulsen des Signals mit der Frequenz $f_1$ zugeführt wie im synchronisierten Zustand. Während der Zeitspanne $t_5$ bis $t_6$ erhält der Teiler jedoch eine gegenüber dem synchronisierten Zustand abweichende Zahl von Impulsen. Die Zahl der Impulse hängt von der Flankenlage ab. Das Ausgangssignal des Teilers 5 wird zum Zeitpunkt $t_6$ wieder von Low- auf High-Pegel wechseln, wobei dieser Zeitpunkt entsprechend der Frequenzverhältnisse von $f_1$ bzw. der dem Teiler 5 zugeführten Impulse in gleicher Weise wie im synchronisierten Zustand so gewählt wurde, daß der Zeitpunkt $t_6$ die zeitliche Mitte eines Impulses des Signals H fällt. Es wird also das Ausgangssignal des Teilers 5 bzw. der Gesamtschaltung wieder auf die zeitliche Mitte der Impulse des Signals H aufsynchronisiert. Dieses Aufsynchronisieren kann auch über mehrere Perioden dauern.

Auch wenn im unsynchronisierten Zustand der Schaltung der Übergang von Low- auf High-Pegel des Signals $H_{PLL}$ zu einem Zeitpunkt stattfindet, in dem kein Impuls in dem Signal H enthalten ist, regelt sich die Schaltung langsam ein. Dies liegt daran, daß zum Zeitpunkt $t_3$ unabhängig vom Zustand des Signals $H_{PLL}$ in diesem Falle das Signal $f_1$ auf den Eingang des Divisors 5 gemäß Fig. 2 geschaltet wird. Der Teilvorgang des Teilers 5 setzt sich dann in oben beschriebener Weise fort, so daß zum Zeitpunkt $t_6$, wobei sich der Einregelvorgang ggf. über mehrere Perioden des Signals $H_{PLL}$ hinziehen kann, an seinem Ausgang ein Wechsel des Signals von Low- auf High-Pegel stattfindet, sofern zu diesem Zeitpunkt das Signal H High-Pegel hat.

Bei der Darstellung gemäß Fig. 3 wurde, wie erläutert, die Frequenz $f_3 = 0$ gewählt. Dies bedeutet eine relativ einfache Auslegung der Schaltung, entsprechend der Darstellung gemäß Fig. 1. Das Impulsdiagramm gemäß Fig. 3 kann grundsätzlich auch für eine Schaltung gemäß Fig. 1 gelesen werden, bei der die Frequenz $f_3$ nicht gleich 0 ist, aber für ein Rasten auf die Vorderflanken der Impulse des Signals H eine kleinere Frequenz haben sollte als das Signal mit der Frequenz $f_2$. In diesem Falle würden während der Zeitspannen $t_2$ bis $t_3$ bzw. $t_6$ bis $t_7$ ebenfalls Impulse gezählt, es würde sich während dieser Zeitspanne jedoch um eine geringere Zahl von Impulsen handeln, als während der übrigen Zeitspannen auf den Teiler 5 gelangen. Die Wahl der Frequenzen $f_1$, $f_2$, $f_3$ und des Divisors D des Teilers 5 der Schaltung gemäß Fig. 1 müßten in diesem Falle so ausgelegt sein, daß das Ausgangssignal des Teilers 5 im synchronisierten Zustand der Schaltung gerade zu den Zeitpunkten $t_2$ bzw. $t_6$ von Low- auf High-Pegel wechselt. Von der Wahl der Frequenzen $f_1$, $f_2$, $f_3$ und des Divisors D hängt also die Phasenlage von H und $H_{PLL}$ im eingeregelten Zustand ab. Werden sie so gewählt, daß $t_2$ bzw. $t_6$ in der Synchronimpulsmitte liegen, ist der Regelbereich symmetrisch bezüglich der Ruhelage. Auch bei dieser Auslegung einer Schaltung beispielsweise gemäß Fig. 1, findet im nicht synchronisierten Zustand der Schaltung ein Aufsynchronisieren auf die Impulse des Signals H statt. Erscheint beispielsweise der zum Zeitpunkt $t_2$ auftretende Übergang von Low- auf High-Pegel im Signal $H_{PLL}$ zeitlich vor die Mitte des Impulses des Signals H, so wird die Zeitspanne $t_2$ bis $t_3$ länger und die Zeitspanne $t_5$ bis $t_6$ größer. Da aber während der Zeitspanne $t_2$ bis $t_3$ deutlich weniger Impulse pro Zeit (relativ niederfrequente Signale) an den Zähler 5 (Fig. 2) gelangen als während der Zeitspanne $t_5$ bis $t_6$ (relativ hochfrequentes Signal), dauert die Zeitspanne $t_2$ bis $t_6$ länger als im synchronisierten Zustand, da der Zähler länger braucht, bis er einmal durchgezählt hat. Die Flanke zum Zeitpunkt $t_6$ verschiebt sich also zeitlich nach hinten, so daß sich die Schaltung langsam aufsynchronisiert. Entsprechendes gilt in umgekehrter Weise für eine zeitlich gegenüber dem Impuls H nach hinten verschobene Flanke des Signals $H_{PLL}$.

Für beide Schaltungsvarianten gilt, daß infolge des unabhängig von dem Zustand des Signals $H_{PLL}$ während der Zeiten $t_3$ bis $t_5$ vorgenommenen Aufschaltens des Signals der Frequenz $f_1$ auf den Teiler 5 immer die gleiche Zahl von Impulsen gezählt wird, also während dieser Zeitspanne keine Nachregelung stattfindet. Eine Nachregelung findet nur während der Zeitspannen $t_1$ bis $t_3$ bzw. $t_5$ bis $t_7$ statt.

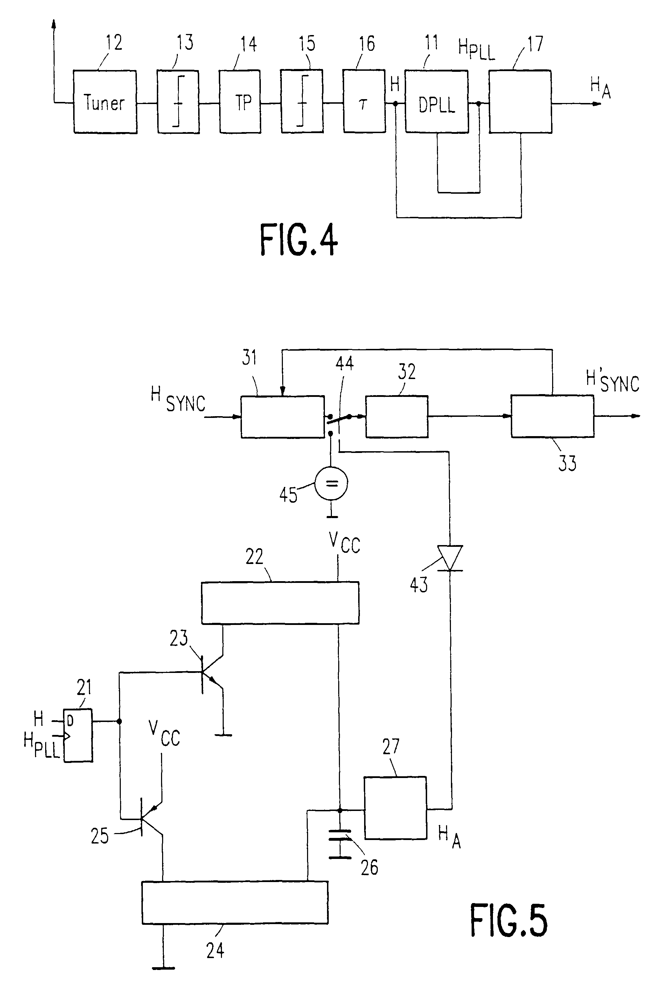

Fig. 4 zeigt ein Blockschaltbild einiger Schaltungselemente eines in der Fig. im übrigen nicht dargestellten Fernsehempfängers. Der oben beschriebene digitale Phasenregelkreis ist hier als Block 11 angedeutet. Das dem Block 11, also dem Phasenregelkreis, eingangsseitig zugeführte Signal H wird aus einem horizontalen Synchronsignal eines Fernsehsignals gewonnen. Dazu ist ein Tuner 12 vorgesehen, dem ein Amplitudensieb 13 nachgeschaltet ist, das in dem Fernsehsignal enthaltene Horizontalsynchronimpulse abtrennt. Ein dem Amplitudensieb 13 nachgeschaltetes Tiefpaßfilter wirkt als Integrator. Sein Ausgangssignal wird einem weiteren Amplitudensieb bzw. einem Komparator zugeführt, der dann ein Ausgangssignal liefert, wenn das von dem Tiefpaß 14 gelieferte Signal einen bestimmten Wert übersteigt. Es wird dann ein Monoflop 16 angestoßen, der einen Impuls liefert. Das Ausgangssignal des Monoflops 16 stellt das Signal H dar, das den digitalen Phasenregelkreis 11 zugeführt wird, bei dem es sich um den Phasenregelkreis nach der Fig. 1 oder Fig. 2 handelt.

Dem Phasenregelkreis 11 ist eine Auswerteeinheit 17 nachgeschaltet, dem sowohl das Ausgangssignal $H_{PLL}$ des Phasenregelkreises wie auch das Ausgangssignal H des Monoflops 16 zugeführt wird. Die Auswerteeinheit 17 ihrerseits liefert ein Ausgangssignal $H_A$, das indiziert, ob der digitale Phasenregelkreis 11 eingerastet hat oder nicht.

Die Vorschaltung der Schaltungselemente 13 bis 16 hat den Vorteil, daß eventuelle Störungen, die dem von dem Tuner 12 gelieferten Fernsehsignal und damit auch den in ihm enthaltenen Horizontalsynchronimpulsen überlagert sein können, weitgehend ausgefiltert werden. Das Monoflop 16 liefert beispielsweise bei überlagertem Rauschen eindeutige Impulse, die von deutlich weniger Störimpulsen überlagert sind.

In Fig. 5 ist die Auswerteeinheit 17 gemäß Fig. 4 detaillierter dargestellt. Die Fig. 5 zeigt ferner einen

Horizontalphasenregelkreis, wie er in einem im übrigen nicht dargestellten Fernsehempfänger vorgesehen sein kann.

Die Auswerteeinheit weist eingangsseitig ein D-Flipflop 21 auf, dessen Takteingang das Ausgangssignal des digitalen Phasenregelkreises zugeführt wird. Auf den D-Eingang des Flipflops 21 ist das Eingangssignal des Phasenregelkreises geführt. Das Flipflop 21 übernimmt also immer mit der positiven Flanke des Signals $H_{PLL}$, also des Ausgangssignals, den momentanen Wert des Eingangssignals des Phasenregelkreises. Ist der Phasenregelkreis gerastet, so ist dieses Eingangssignal zu diesen Zeitpunkten immer auf High-Pegel. Ist der Phasenregelkreis nicht gerastet, so hat das Signal zu diesen Zeitpunkten Low-Pegel. Das Ausgangssignal des D-Flipflops 21 hat also High-Pegel im gerasteten Zustand der Schaltung und Low-Pegel im nicht gerasteten Zustand.

Dieses Signal wird einer ersten Stromspiegelschaltung 22 mit einem Transistor 23 sowie einer zweiten Stromspiegelschaltung 24 mit einem Transistor 25 zugeführt. Während derjenigen Zeiten, in denen das Ausgangssignal des D-Flipflops 21 High-Pegel hat, wird der Transistor 23 leitend geschaltet und die erste Stromspiegelschaltung 22 liefert einen Strom, mit dem ein gegen Masse geschaltete Kapazität 26 aufgeladen wird.

Während derjenigen Zeiten, in denen das Ausgangssignal des D-Flipflops 21 Low-Pegel hat, wird der Transistor 25 leitend geschaltet und die zweite Stromspiegelschaltung 24 entlädt die Kapazität 26. Die über der Kapazität 26 erscheinende Spannung wird mittels eines Komparators 27 mit Hysteresis ausgewertet, welcher ein High-Signal liefert, wenn die Spannung einen bestimmten Wert überschreitet und welcher ein Low-Signal liefert, wenn die Spannung diesen Wert unterschreitet.

Dabei ist mit der Höhe des Lade- bzw. Entladestromes, also der Ströme der beiden Stromspiegelschaltung 22 bzw. 24 die Gewichtung einstellbar. Es wurde experimentiell ein Lade-Entladestromverhältnis von 4 : 1 bis 7 : 1 gefunden. Ist das Stromverhältnis höher, wird auch Rauschen als Signal erkannt, ist es niedriger, wird ein verrauschtes Signal nicht mehr sicher als Signal erkannt.

Das Ausgangssignal $H_A$ des Komparators 27 gibt also in zeitlich aufintegrierter Form an, ob der Phasenregelkreis 11 gemäß Fig. 4 eingerastet hat oder nicht.

Diese Information kann nun in einem Fernsehempfänger dazu eingesetzt werden, einen in diesem vorgesehenen Horizontalphasenregelkreis entsprechend zu steuern. Dieser Horizontalphasenregelkreis, dessen Ausgangssignal beispielsweise dazu herangezogen wird, die Horizontalablenkung einer Bildröhre zur Darstellung des Bildes anzusteuern, hat die Eigenschaft, daß sie bei fehlendem Eingangssignal ein nahezu beliebiges Ausgangssignal liefert. Dies wiederum hat zur Folge, daß eine Darstellung auf dem Bildschirm nicht mehr möglich ist.

Das Ausgangssignal $H_A$ des Komparators 27 wird nun dazu herangezogen, den Oszillator des Horizontalphasenregelkreises auf seinen Sollwert zu schalten und so eine Bildschirmdarstellung zu gestatten, auch wenn kein Signal empfangen wird.

In der Fig. 5 ist der Horizontalphasenregelkreis mittels eines Phasenkomparators 31, eines ihm nachgeschalteten Filters 32 und eines steuerbaren Oszillators 33 angedeutet. Dieser Phasenregelkreis soll in bekannter Weise auf die Horizontalsynchronimpulse, die in einem Fernsehsignal enthalten sind, einrasten. Dazu wird der Oszillator 33 eingangsseitig so gesteuert, daß er an seinem Ausgang ein Signal mit der gewünschten Frequenz liefert. Dieses Signal ist in der Fig. 5 mit $H'_{SYNC}$ bezeichnet.

Wird kein Fernsehsignal empfangen, so kann dieses Steuersignal für den Oszillator 33 nahezu beliebige und insbesondere auch schwankende Werte annehmen, so daß auch das Signal $H'_{SYNC}$ schwankende Werte annimmt und eine Bildschirmdarstellung nicht mehr möglich ist.

Genau in diesem Falle, in dem also kein Fernsehsignal empfangen wird, ist jedoch der erfindungsgemäße digitale Phasenregelkreis nicht gerastet und der Komparator 27 liefert ein Ausgangssignal $H_A$, das Low-Pegel hat. Dieses Signal $H_A$ wird nun dazu herangezogen, eine kathodenseitig mit dem Ausgang des Komparators 27 verbundene Diode 43 zu schalten. Die Diode 43 ist anodenseitig auf einen Schalter 44 geschaltet, den sie steuert. Mittels des Schalters 44 ist alternativ der Ausgang des Phasenkomparators 33 oder ein Ausgang einer Gleichspannungsquelle 45 auf den Eingang des Filters 32 schaltbar.

Wird durch den erfindungsgemäßen Phasenregelkreis ein empfangenes Fernsehsignal bzw. die in ihm enthaltenen Horizontalsynchronimpulse erkannt, so hat das Ausgangssignal des Komparators 27 High-Pegel. Die Diode 43 ist dann leitend geschaltet und der Schalter 44 auf den Ausgang des Phasenkomparators 31 der $H_{PLL}$ geschaltet. Der Horizontalphasenregelkreis, der aus den Elementen 31, 32 und 33 gebildet ist, arbeitet dann in normaler Weise, d.h. er regelt sich ein auf die in dem Fernsehsignal enthaltenen Horizontalsynchronsignale.

Wird durch den erfindungsgemäßen Phasenregelkreis dagegen kein Fernsehsignal erkannt, so hat das Ausgangssignal $H_A$ Low-Pegel, so daß die Diode 43 gesperrt ist. Der Schalter 44 ist dann auf den Ausgang des Gleichspannungsgenerators 45 geschaltet. Die von diesem gelieferte Gleichspannung gelangt auf den Eingang des steuerbaren Oszillators 33. Die von dem Generator 45 gelieferte Gleichspannung ist dabei so gewählt, daß der steuerbare Oszillator 33 ein Signal einer Soll-Horizontalfrequenz liefert, d.h. also derjenigen Frequenz, die ein in einem Fernsehsignal enthaltenes Horizontalsynchronsignal normalerweise hat. Auf diese Weise wird die Ansteuerung der Ablenkschaltung des Fernsehgerätes etc. möglich, so daß, obwohl kein Fernsehsignal empfangen wird, gleichwohl Darstellungen auf dem Bildschirm möglich sind, bei denen es sich beispielsweise um sogenannte On-Screen-Darstellungen handeln kann, also um Darstellungen bestimmter Einstellparameter des Fernsehgerätes.

**Patentansprüche**

1. Digitaler Phasenregelkreis (PLL), welcher auf ein rechteckförmiges Eingangssignal mit einer Frequenz $f_E$ einregelt und welcher einen Umschalter (1) aufweist, der auf Rechtecksignale verschiedener Frequenz umgeschaltet wird und dem ein Hauptteiler (5), welcher mit einem Divisor D arbeitet, nachgeschaltet ist, der das Ausgangssignal des Phasenregelkreises bildet, wobei der Umschalter (1) in Abhängigkeit dieses Ausgangssignals und des Eingangssignals betätigt wird, dadurch gekennzeichnet,

- daß der Umschalter zwischen einem ersten Rechtecksignal mit der Frequenz $f_1$, einem zweiten Rechtecksignal mit der zweiten Frequenz $f_2$ und einem dritten Rechtecksignal mit der Frequenz $f_3$ umgeschaltet wird, wobei gilt:

$$f_1 \cdot 1/D = f_E \text{ sowie } k \cdot f_1 = f_2 + (k-1) \cdot f_3,$$

mit k als natürlicher Zahl zwischen 1 und unendlich;

- daß eine Umschaltlogik (6) vorgesehen ist, welche den Umschalter (1) in der Weise steuert, daß er im Zeitraum zwischen zwei Impulsen des Ausgangssignals auf das Signal mit der ersten Frequenz $f_1$ und daß er während eines Impulses des Ausgangssignals und eines ersten Zustands des Eingangssignals auf das Signal mit der zweiten Frequenz $f_2$ und während eines Impulses des Ausgangssignals und eines zweiten Zustands des Eingangssignals auf das Signal mit der dritten Frequenz $f_3$ geschaltet wird,

- und daß für ein Einrasten der Schaltung auf die Vorderflanken der Impulse des Eingangssignals $f_2 > f_3$ bzw. auf die Rückflanken $f_2 < f_3$ gilt.

2. Phasenregelkreis nach Anspruch 1,
dadurch gekennzeichnet, daß gilt: $2 \cdot f_1 = f_2 + f_3$.

3. Phasenregelkreis nach Anspruch 1 oder 2,
dadurch gekennzeichnet, daß Teiler (2, 3, 4) vorgesehen sind, mittels derer die drei Rechtecksignale mit den Frequenzen $f_1$, $f_2$ und $f_3$ durch Teilung eines Generatorrechtecksignals mit einer Frequenz $f_0$ gewonnen werden.

4. Phasenregelkreis nach Anspruch 3,
dadurch gekennzeichnet, daß die Teiler (2, 3, 4) mit ganzzahligen Divisoren arbeiten.

5. Phasenregelkreis nach Anspruch 2,
dadurch gekennzeichnet, daß gilt: $f_2 = 2f_1$ und $f_3 = 0$.

6. Phasenregelkreis nach Anspruch 5,
dadurch gekennzeichnet, daß ein Rechtecksignal-Generator vorgesehen ist, welcher ein Signal mit der zweiten Frequenz $f_2$ liefert, das einem Teiler mit dem Divisor 2 zugeführt wird, dessen Ausgangssignal das Rechtecksignal mit der ersten Frequenz $f_1$ darstellt.

7. Phasenregelkreis nach einem der Ansprüche 1 bis 6,
dadurch gekennzeichnet, daß der Phasenregelkreis in einem Fernsehempfänger zur Detektion der Horizontalsynchronimpulse eines gegebenenfalls empfangenen Fernsehsignals in einem Ausgangssignal eines Tuners des Fernsehempfängers vorgesehen ist.

8. Phasenregelkreis nach den Ansprüchen 5, 6 und 7,
dadurch gekennzeichnet, daß der Rechtecksignal-Generator mit einer Frequenz $f_0 = 843,75$ MHz arbeitet und daß im Hauptteiler eine Division durch D = 27 vorgenommen wird.

9. Fernsehempfänger mit Phasenregelkreis nach Anspruch 7 oder 8,
dadurch gekennzeichnet, daß das Ausgangssignal des Tuners einem Amplitudensieb (13) zugeführt wird, mittels dessen die Synchronimpulse abgetrennt werden, welche einem nachgeschalteten, als Integrator wirksamen Tiefpaßfilter (14) zugeführt werden, dessen Ausgangssignal in einem Komparator (15) mit einer Schaltschwelle verglichen wird, wobei bei Überschreiten der Schaltschwelle ein Monoflop (16) angestoßen wird, dessen Ausgangssignal das Eingangssignal des Phasenregelkreises darstellt.

10. Fernsehempfänger mit Phasenregelkreis nach Anspruch 7, 8 oder 9,
dadurch gekennzeichnet, daß dem Phasenregelkreis eine Auswerteschaltung (17) nachgeschaltet ist, in welcher ein D-Flipflop (21) vorgesehen ist, dessen D-Eingang das Eingangssignal des Phasenregelkreises und dessen Takteingang das Ausgangssignal des Phasenregelkreises zugeführt wird und dessen Ausgangssignal zwei Stromspiegel (22, 24) steuert, deren Ausgänge einen gegen ein Bezugspotential geschalteten Kondensator (26) geführt werden, wobei eine Stromspiegelschaltung den Kondensator auflädt und die andere ihn entlädt, und daß die Spannung über dem Kondensator (26) einem Komparator (27) zugeführt wird, dessen Ausgangssignal indiziert, ob der Phasenregelkreis auf ein Fernsehsignal mit Horizontalsynchronimpulsen eingerastet hat oder nicht.

11. Fernsehempfänger mit Phasenregelkreis nach Anspruch 10,
dadurch gekennzeichnet, daß in dem Fernsehempfänger ein Horizontalphasenregelkreis (31, 32, 33) vorgesehen ist, welchem das in einem empfangenen Fernsehsignal enthaltene Horizontalsynchronsignal zugeführt wird, welcher einen Phasenkomparator (31) und einen steuerbaren Oszillator (33) aufweist, daß der Eingang des steuerbaren Oszillators (33) über einen steuerbaren Schalter (44) auf den Ausgang des Phasenkomparators (31) oder einen Ausgang einer Gleichspannungsquelle schaltbar ist, welche eine Spannung liefert, welche den Oszillator (33) auf einer vorgebbaren Soll-Horizontalfrequenz schwingen läßt, und daß der steuerbare Schalter (44) in in Abhängigkeit des Ausgangssignals ($H_A$) des Komparators (27) so gesteuert wird, daß der steuerbare Oszillator (31) bei nicht gerastetem Phasenregelkreis ein Signal mit der Soll-Horizontalfrequenz abgibt.

## Claims

1. A digital phase-locked loop (PLL) which responds to a square-wave input signal of a frequency $f_E$ and comprises a change-over switch (1) which is switched in response to square-wave signals of different frequencies and precedes a main divider (5) operating with a divisor D and constituting the output signal of the phase-locked loop, the change-over switch (I) being activated in dependence upon said output signal and the input signal, characterized in that

   - the change-over switch is switched between a first square-wave signal of the frequency $f_1$, a second square-wave signal of the second frequency $f_2$ and a third square-wave signal of the frequency $f_3$, in which:

   $$f_1 \cdot 1/D = f_E \text{ and } k \cdot f_1 = f_2 + (k-1) \cdot f_3,$$

   with k being a natural number between 1 and infinity;
   - a switching logic (6) is provided which controls the change-over switch (1) in such a way that it is switched to the signal of the first frequency $f_1$ in the period between two pulses of the output signal, and to the signal of the second frequency $f_2$ during a pulse of the output signal and a first state of the input signal, and to the signal of the third frequency $f_3$ during a pulse of the output signal and a second state of the input signal,
   - and in that $f_2 > f_3$ when the circuit locks in on the leading edges of the pulses of the input signal and $f_2 < f_3$ when the circuit locks in on the trailing edges.

2. A phase-locked loop as claimed in Claim 1, characterized in that $2 \cdot f_1 = f_2 + f_3$.

3. A phase-locked loop as claimed in Claim 1 or 2, characterized in that dividers (2, 3, 4) are provided by means of which the three square-wave signals of the frequencies $f_1$, $f_2$ and $f_3$ are gained by dividing a generator square-wave signal of a frequency $f_0$.

4. A phase-locked loop as claimed in Claim 3, characterized in that the dividers (2, 3, 4) operate with integral divisors.

5. A phase-locked loop as claimed in Claim 2, characterized in that $f_2 = 2f_1$ and $f_3 = 0$.

6. A phase-locked loop as claimed in Claim 5, characterized in that a square-wave signal generator is provided which supplies a signal of the second frequency $f_2$ which is applied to a divider operating with the divisor 2 whose output signal represents the square-wave signal of the first frequency $f_1$.

7. A phase-locked loop as claimed in any one of Claims 1 to 6, characterized in that the phase-locked loop is arranged in a television receiver for detecting the horizontal sync pulses of a possibly received television signal in an output signal of a tuner of the television receiver.

8. A phase-locked loop as claimed in Claims 5, 6 and 7, characterized in that the square-wave signal generator operates at a frequency $f_0$ of 843.75 MHz and in that the main divider performs a division by D = 27.

9. A television receiver including a phase-locked loop as claimed in Claim 7 or 8, characterized in that the output signal of the tuner is applied to an amplitude separator (13) by means of which the sync pulses are separated and applied to a subsequently arranged low-pass filter (14) operating as an integrator whose output signal is compared in a comparator (15) with a switching threshold, a monoflop (16), whose output signal represents the input signal of the phase-locked loop, being triggered when the switching threshold is exceeded.

10. A television receiver including a phase-locked loop as claimed in Claim 7, 8 or 9, characterized in that the phase-locked loop precedes an evaluation circuit (17) which includes a D flip-flop (21) whose D input receives the input signal of the phase-locked loop and whose clock input receives the output signal of the phase-locked loop and whose output signal controls two current mirrors (22, 24) whose output currents are applied to a capacitor (26) connected to a reference potential, one current mirror circuit charging the capacitor and the other discharging the capacitor, and in that the voltage across the capacitor (26) is applied to a comparator (27) whose output signal indicates whether the phase-locked loop has locked in or not locked in on a television signal comprising horizontal sync pulses.

**11.** A television receiver including a phase-locked loop as claimed in Claim 10, characterized in that the television receiver includes a horizontal phase-locked loop (31, 32, 33) which receives the horizontal synchronizing signal in a received television signal, said loop comprising a phase comparator (31) and a controllable oscillator (33), in that the input of the controllable oscillator (33) is connectable to the output of the phase comparator (31) or to an output of a DC source *via* a controllable switch (44), said DC source supplying a voltage causing the oscillator (33) to oscillate at a predeterminable nominal horizontal frequency, and in that the controllable switch (44) is controlled in dependence upon the output signal ($H_A$) of the comparator (27) in such a way that the controllable oscillator (31) supplies a signal at the nominal horizontal frequency when the phase-locked loop has not locked in.

## Revendications

**1.** Circuit numérique de verrouillage de phase (PLL) qui règle sur un signal d'entrée rectangulaire avec une fréquence $f_E$ et qui présente un commutateur (1) qui est commuté sur des signaux rectangulaires de fréquences différentes et en aval duquel est monté un diviseur principal (5) qui travaille avec un terme diviseur (D) qui forme le signal de sortie du circuit de verrouillage de phase, le commutateur (1) étant actionné en fonction de ce signal de sortie et du signal d'entrée,

caractérisé en ce

- que le commutateur est commuté entre un premier signal rectangulaire avec la fréquence $f_1$, un deuxième signal rectangulaire avec la deuxième fréquence $f_2$ et un troisième signal rectangulaire avec la fréquence $f_3$, auquel cas :

$$f_1 \cdot 1/D = f_E \text{ ainsi que } k \cdot f_1 = f_2 + (k-1) \cdot f_3$$

avec K comme nombre naturel compris entre 1 et l'infini;
- qu'une logique de commutation (6) est prévue et commande le commutateur (1) de telle manière qu'il commute dans l'intervalle de temps entre deux impulsions du signal de sortie sur le signal avec la première fréquence $f_1$ et qu'il commute pendant une impulsion du signal de sortie et un premier état du signal d'entrée sur le signal avec la deuxième fréquence $f_2$ et pendant une impulsion du signal de sortie et un deuxième état du signal d'entrée sur le signal avec la troisième fréquence $f_3$,
- et en ce que, pour un verrouillage du circuit sur les flancs de montée des impulsions du signal

d'entrée, $f_2 > f_3$ ou, sur les flancs arrière, $f_2 < f_3$.

**2.** Circuit de verrouillage de phase selon la revendication 1,
caractérisé en ce que $2 \cdot f_1 = f_2 + f_3$.

**3.** Circuit de verrouillage de phase selon la revendication 1 ou 2,
caractérisé en ce qu'il est prévu des diviseurs (2, 3, 4) à l'aide desquels les trois signaux rectangulaires avec les fréquences $f_1$, $f_2$ et $f_3$ sont obtenus par division d'un signal rectangulaire du générateur avec une fréquence $f_0$.

**4.** Circuit de verrouillage de phase selon la revendication 3,
caractérisé en ce que les diviseurs (2, 3, 4) travaillent avec des termes diviseurs entiers.

**5.** Circuit de verrouillage de phase selon la revendication 2,
caractérisé en ce que $f_2 = 2f_1$ et $f_3 = 0$.

**6.** Circuit de verrouillage de phase selon la revendication 5,
caractérisé en ce qu'il est prévu un générateur de signaux rectangulaires qui produit un signal avec la deuxième fréquence $f_2$ qui est amené à un diviseur avec le terme diviseur 2, dont le signal de sortie représente le signal rectangulaire avec la première fréquence $f_1$.

**7.** Circuit de verrouillage de phase selon l'une des revendications 1 à 6,
caractérisé en ce que le circuit de verrouillage de phase est prévu dans un récepteur de télévision pour la détection des impulsions de synchronisation horizontale d'un signal de télévision éventuellement reçu en un signal de sortie d'un syntoniseur du récepteur de télévision.

**8.** Circuit de verrouillage selon l'une des revendications 5, 6 et 7,
caractérisé en ce que le générateur de signaux rectangulaires travaille à une fréquence $f_0 = 843,75$ MHz et qu'une division par D = 27 est effectuée dans le diviseur principal.

**9.** Récepteur de télévision avec circuit de verrouillage de phase selon la revendication 7 ou 8,
caractérisé en ce que le signal de sortie du syntoniseur est amené à un séparateur de synchronisation (13) à l'aide duquel sont séparées les impulsions de synchronisation qui sont amenées à un filtre passe-bas (14) monté en aval et tenant lieu d'intégrateur dont le signal de sortie est comparé dans un comparateur (15) avec un seuil de commutation, une bascule monostable (16) dont le signal de sortie représente le signal d'entrée du circuit de verrouillage de phase étant déclenchée en cas de dépassement du seuil de commutation.

10. Récepteur de télévision avec circuit de verrouillage de phase selon la revendication 7, 8 ou 9,

caractérisé en ce qu'en aval du circuit de verrouillage de phase est monté un circuit d'évaluation (17) dans lequel est prévue une bascule bistable D (21) à l'entrée D de laquelle est amené le signal d'entrée du circuit de verrouillage de phase et à l'entrée de rythme de laquelle est amené le signal de sortie du circuit de verrouillage de phase et dont le signal de sortie commande deux niveaux de courant (22, 24) dont les sorties sont amenées à un condensateur (26) commuté sur un potentiel de référence, un circuit de niveau du courant chargeant le condensateur et l'autre le déchargeant, et en ce que la tension est amenée par l'intermédiaire du condensateur (26) à un comparateur (27) dont le signal de sortie indique si le circuit de verrouillage de phase a ou non verrouillé sur un signal de télévision avec des impulsions de synchronisation horizontale.

11. Récepteur de télévision avec circuit de verrouillage de phase selon la revendication 10,

caractérisé en ce qu'il est prévu un circuit de verrouillage de phase horizontale (31, 32, 33) dans le récepteur de télévision auquel est amené le signal de synchronisation horizontale contenu dans un signal de télévision reçu qui présente un comparateur de phases (31) et un oscillateur commandable (33), en ce que l'entrée de l'oscillateur commandable (33) peut être commuté par l'intermédiaire d'un commutateur commandable (44) sur la sortie du comparateur de phases (31) ou sur une sortie d'une source de tension continue qui produit une tension qui fait fluctuer l'oscillateur (33) sur une fréquence horizontale de consigne à prédéterminer et en ce que le commutateur commandable (44) est commandé en fonction du signal de sortie ($H_A$) du comparateur (27), en ce que l'oscillateur commandable (31) délivre un signal avec la fréquence horizontale de consigne en cas de régulateur de phase non verrouillé.

FIG.1

FIG.2

FIG.3

EP 0 544 355 B1

FIG.4

FIG.5